# EUROPEAN PATENT SPECIFICATION

(11) **EP 0 978 936 B1**
(45) Date of publication and mention of the grant of the patent: **17.03.2004**
(21) Application number: 99115355.2
(22) Date of filing: 03.08.1999
(51) Int. Cl.: H03F 3/45

(54) **Isolator circuit**
Trennschaltung
Circuit séparateur

(30) Priority: 03.08.1998 JP 21903798
(43) Date of publication of application: 09.02.2000
(73) Proprietor: PIONEER ELECTRONIC CORPORATION, Meguro-ku, Tokyo (JP)
(72) Inventor: Iigai, Yukiya, c/o Pioneer Electronic Corporation, Kawagoe-shi, Saitama-ken 350-0822 (JP); Inohana, Haruyuki, c/o Pioneer Electronic Corp., Kawagoe-shi, Saitama-ken 350-0822 (JP); Ozawa, Akio, c/o Pioneer Electronic Corporation, Kawagoe-shi, Saitama-ken 350-0822 (JP); Higuma, Takeshi, c/o Pioneer Electronic Corp., Kawagoe-shi, Saitama-ken 350-0822 (JP)
(74) Representative: Popp, Eugen, Dr.

(56) References cited:
- EP-A- 0 482 291
- WO-A-95/21487

## Description

### BACKGROUND OF THE INVENTION

The present invention relates to an isolator circuit for isolating or reducing noises in balanced inputs, wherein even if the noises are at a reference potential, noises are isolated.

In a system such as a car audio system, the connection between each devices such as a head unit and a CD changer is long. Hence, there is generated a potential difference between the reference potentials of both the devices. A so-called ground isolator circuit is connected to the signal line so that the reference potential of a device can be isolated from that of other devices. Examples of isolator circuits are known e.g. from EP-A-0 482 291 or WO-A-95 21487.

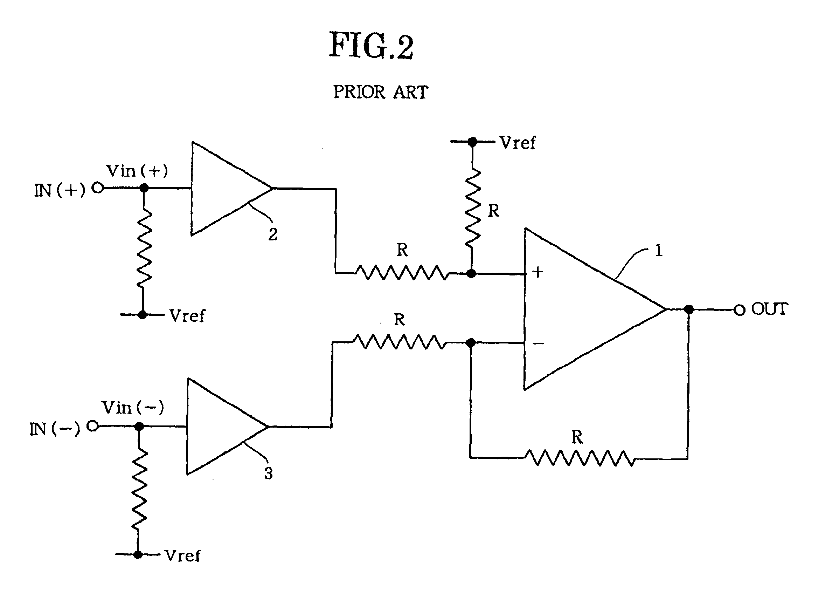

Fig. 2 shows a conventional isolator circuit, which consists a part of a balancing amplifier as disclosed in Japanese Patent Application Laid-Open 10-32439,

Referring to Fig. 2, the isolator circuit generates a difference between a balanced inverting input Vin(-) and a balanced non-inverting input Vin(+) which are fed to an opamp 1. In-phase noises are removed from the applied balanced input by the circuit.

In order to reduce the voltage of the noises, it is generally necessary in such an isolator circuit to allow a large electric current to flow at a stage before the opamp 1. Moreover, in the isolator circuit, the resistance of each of four resistors R provided therein must be small, or else the voltage of the noises cannot be reduced. Hence the resistors R of a small resistance are used. However, when the resistance of the resistors R is small, the opamp 1 must have a large load driving capacity, and in addition, the input impedance is decreased.

In order to solve the problem, in the isolator circuit shown in Fig. 2, buffers 2 and 3 are connected to the non-inverting input terminal and the inverting input terminal of the opamp 1, respectively. When the buffers 2 and 3 are provided, the consumed electric current is increased, and the size of the circuit is also increased. Accordingly, when the isolator circuit is associated with an IC, the electric current consumed by the IC is increased. In addition, the area taken by the isolator circuit in the IC is increased, thereby causing a difficulty in miniaturizing the IC.

### SUMMARY OF THE INVENTION

An object of the present invention is to provide an isolator circuit which is small in size and consumes less electric current in view of the above described problems in the conventional circuit.

According to the present invention, there is provided an isolator circuit comprising a paired first differential circuit having a first active element and a second active element, a paired second differential circuit having a third active element and a fourth active element, a differential output circuit, wherein a control terminal of the first active element is connected to one of input terminals for balanced input signals, and an output terminal thereof is connected to an output terminal of the third active element, a control terminal of the second active element is AC grounded, an output terminal thereof is connected to an output terminal of the fourth active element, an output terminal of the differential output circuit is connected to a control terminal of the third active element, the output terminal of the third active element is connected to one of input terminals of the differential output circuit, the output terminal of the fourth active element is connected to the other input terminal of the differential output circuit, and a control terminal of the fourth active element is connected to the other input terminal for the balanced input signals.

Each of the first through fourth active elements is a transistor.

Emitter or source terminals of the first through fourth active elements are connected to a DC source through resistors, each having a predetermined resistance.

These and other objects and features of the present invention will become more apparent from the following detailed description with reference to the accompanying drawings.

### BRIEF DESCRIPTION OF DRAWINGS

Fig. 1 shows a circuitry of an isolator circuit according to the present invention; and
Fig. 2 shows a circuitry of a conventional isolator circuit.

### DETAILED DESCRIPTION OF THE PREFERRED EMBODIMENT

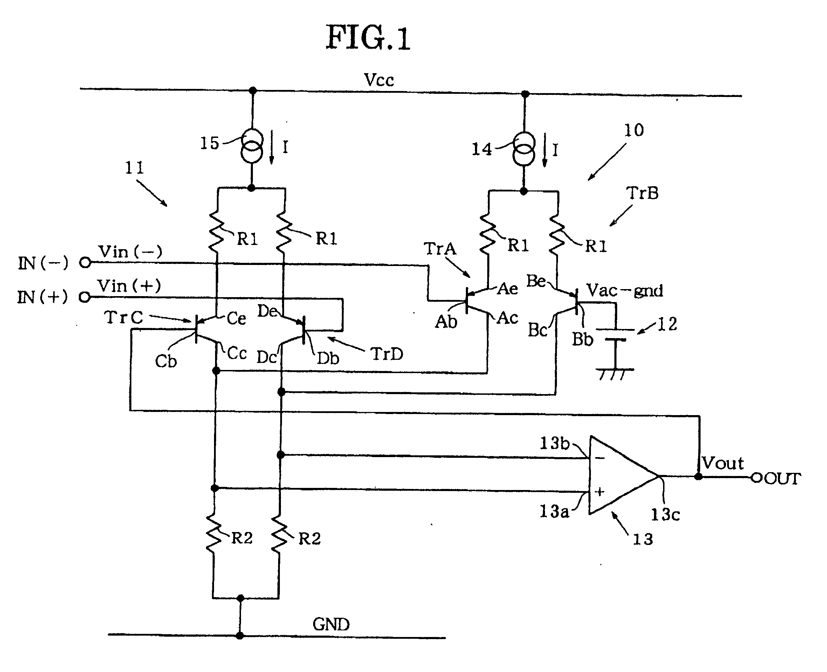

Referring to Fig. 1, an isolator circuit according to the present invention comprises a paired first differential circuit 10 having a pair of transistors TrA and TrB, a paired second differential circuit 11 having a pair of transistors TrC and TrD, and a differential output circuit 13 (hereinafter called an opamp).

A base Ab of the transistor TrA of the first differential circuit 10 is connected to an input terminal IN(-) of the balanced inputs while a collector Ac is connected to a collector Cc of the transistor TrC of the second differential circuit 11. An emitter Ae is connected to a DC source 14 through a resistor R1.

A base Bb of the transistor TrB of the first differential circuit 10 is AC-grounded while a collector Bc is connected to a collector Dc of the transistor TrD of the second differential circuit 11. An emitter Be is connected to the source 14 through another resistor R1. A DC bias voltage 12 is applied to the base Bb so as to provide a voltage Vac-gnd for the output Vout of the opamp 13.

The transistor TrC of the second differential circuit 11 has a base Cb which is connected to an output terminal 13c of the opamp 13, a collector Cc connected to a non-inverting input terminal 13a of the opamp 13 and grounded through a resistor R2. An emitter Ce is connected to a DC source 15 by way of a resistor R1.

The transistor TrD of the second differential circuit 11 has a base Db which is connected to an input terminal IN(+) of the balance inputs, a collector Dc connected to an inverting input terminal 13b of the opamp 13 and grounded through a resistor R2. An emitter De is connected to the source 15 by way of another resistor R1.

In the above described isolator circuit, the first differential circuit 10 compares an input voltage Vin(-) fed through the input terminal IN(-) to the base Ab of the transistor TrA with the reference voltage Vac-gnd at the base Bb of the transistor TrB.

When the input voltage Vin (-) is equal to the reference voltage Vac-gnd, equal currents flow through the transistors TrA and TrB. Thus, there is not generated a potential difference between the collector Cc of the transistor TrC and the collector Dc of the transistor TrD of the second differential circuit 11 caused by the current from the first differential circuit 10.

Since a differential output voltage Vout of the opamp 13 is negatively fed back to the transistor TrC of the second differential circuit 11, the output voltage Vout becomes the same as the input voltage Vin(+) applied through the input terminal IN(+) as described hereinafter.

If the input voltage Vin(+) increases, the current passing through the transistor TrD reduces. Accordingly, the potential at the end of the resistor R2 reduces, so that the output voltage Vout increases. Consequently, the current passing through the transistor TrC decreases until the current becomes equal to the current passing the transistor TrD, at the time the output voltage Vout is equal to the input voltage Vin(+).

On the other hand, when the input voltage Vin(-) is different from the reference voltage Vac-gnd, a current corresponding to the difference between the voltages Vin(-) and Vac-gnd flows from the transistor TrA of the first differential circuit 10 to the resistor R2 connected to the collector Cc of the transistor TrC provided in the second differential circuit 11. Thus, there is generated a potential difference between the collector Cc of the transistor TrC and the collector Dc of the transistor TrD caused by the current from the first differential circuit 10. Accordingly, the potential difference from the first differential circuit 10 is represented by the differential output voltage Vout of the differential output circuit 13.

Namely, the negative feedback of the output voltage Vout is so effectuated that the difference between the differential output voltage Vout applied to the base Cb of the transistor TrC of the second differential circuit 11 and the input voltage Vin(+) applied to the base Db of the transistor TrD becomes equal to the difference between the input voltage Vin(-) and the reference voltage Vac-gnd.

Since the input voltage Vin(+) includes the in-phase input voltage Vin(-), the input voltage Vin(-) including noises is canceled by removing the difference between the potentials at the resistors R2 at the opamp 13.

The cancel level of the in-phase component is determined by selecting the resistance of the resistors R1 of the first and second differential transistor devices 10 and 11.

The transistors TrA, TrB, TrC, TrD in the first and second differential circuits 10 and 11 may be FETs.

In the above-described isolator circuit, the DC bias applied to the base Bb of the transistor TrB of the first differential circuit 10 becomes the reference voltage. Hence, the isolator circuit can be used as a so-called ground isolator circuit. When provided in a car audio system wherein the potential differences are generated between devices such as the head unit and CD changer, reference voltages of devices can be isolated from one another. In such a case, the terminal IN(+) is connected to a line for the signal between the head unit and the CD changer, and the terminal IN(-) is connected to the ground line there-between.

While the invention has been described in conjunction with preferred specific embodiment thereof, it will be understood that this description is intended to illustrate and not limit the scope of the invention, which is defined by the following claims.

## Claims

1. An isolator circuit comprising:
a paired first differential circuit (10) having a first active element (TrA) and a second active element (TrB);
a paired second differential circuit (11) having a third active element (TrC) and a fourth active element (TrD);
a differential output circuit (13); wherein
a control terminal (Ab) of the first active elements (TrA) is connected to one of input terminals (IN(-)) for balanced input signals, and an output terminal (Ac) thereof is connected to an output terminal (Co) of the third active element (TrC);
a control terminal (Bb) of the second active element (TrB) is AC grounded (12), an output terminal (Bc) thereof is connected to an output terminal (Dc) of the fourth active element (TrD);
an output terminal (13c) of the differential output circuit (13) is connected to a control terminal (Cb) of the third active element (TrC);
the output terminal (Cc) of the third active element (TrC) is connected to one of input terminals (13a) of the differential output circuit (13).
the output terminal (Dc) of the fourth active element (TrD) is connected to the other input terminal (13b) of the differential output circuit (13); and
a control terminal (Db) of the fourth active element (TrD) is connected to the other input terminal (IN(+)) for the balanced input signals.

2. The isolator circuit according to claim 1 wherein each of the first through fourth active elements (TrA,TrB,TrC,TrD) is a transistor.

3. The isolator circuit according to claim 1 wherein a constant voltage (12) is applied to the control terminal (Bb) of the second active element (TrB).

4. The isolator circuit according to claim 2 wherein emitter or source terminals of the first through fourth active elements are connected to a DC source (14,15) through resistors (R1), each having a predetermined resistance.

## Patentansprüche

1. Trennschaltung, die folgendes aufweist:
eine paarige erste Differenzschaltung (10), die ein erstes aktives Element (TrA) und ein zweites aktives Element (TrB) hat;
eine paarige zweite Differenzschaltung (11), die ein drittes aktives Element (TrC) und ein viertes aktives Element (TrD) hat;
eine Differenzausgangsschaltung (13); wobei
ein Steueranschluß (Ab) des ersten aktiven Elements (TrA) mit dem einen von Eingangsanschlüssen (IN(-)) für symmetrische Eingangssignale verbunden ist und ein Ausgangsanschluß (Ac) davon mit einem Ausgangsanschluß (Cc) des dritten aktiven Elements (TrC) verbunden ist;
ein Steueranschluß (Bb) des zweiten aktiven Elements (TrB) wechselstromgeerdet ist (12) und ein Ausgangsanschluß (Bc) davon mit einem Ausgangsanschluß (Dc) des vierten aktiven Elements (TrD) verbunden ist;
ein Ausgangsanschluß (13c) der Differenzausgangsschaltung (13) mit einem Steueranschluß (Cb) des dritten aktiven Elements (TrC) verbunden ist;
der Ausgangsanschluß (Cc) des dritten aktiven Elements (TrC) mit dem einen von Eingangsanschlüssen (13a) der Differenzausgangsschaltung (13) verbunden ist;
der Ausgangsanschluß (Dc) des vierten aktiven Elements (TrD) mit dem anderen Eingangsanschluß (13b) der Differenzausgangsschaltung (13) verbunden ist; und
ein Steueranschluß (Db) des vierten aktiven Elements (TrD) mit dem anderen Eingangsanschluß (IN(+)) für die symmetrischen Eingangssignale verbunden ist.

2. Trennschaltung nach Anspruch 1, wobei jedes von dem ersten bis vierten aktiven Element (TrA, TrB, TrC, TrD) ein Transistor ist.

3. Trennschaltung nach Anspruch 1, wobei dem Steueranschluß (Bb) des zweiten aktiven Elements (TrB) eine konstante Spannung (12) zugeführt wird.

4. Trennschaltung nach Anspruch 2, wobei Emitter- oder Sourceanschlüsse des ersten bis vierten aktiven Elements über Widerstände (R1), die jeweils einen vorbestimmten Widerstandswert haben, mit einer Gleichstromquelle (14, 15) verbunden sind.

## Revendications

1. Circuit d'isolation comprenant :
- un premier circuit différentiel à paire (10) possédant un premier élément actif (TrA) et un second élément actif (TrB) ;
- un second circuit différentiel à paire (11) possédant un troisième élément actif (TrC) et un quatrième élément actif (TrD) ;
- un circuit de sortie différentielle (13) ;
dans lequel :
- une borne de commande (Ab) du premier élément actif (TrA) est connectée à une des bornes d'entrée (IN(-)) pour les signaux d'entrée compensée et sa borne de sortie (Ac) est connectée à une borne de sortie (Cc) du troisième élément actif (TrC) ;
- une borne de commande (Bb) du second élément actif (TrB) est mise à la terre C.A. (12), sa borne de sortie (Bc) étant connectée à une borne de sortie (Dc) du quatrième élément actif (TrD) ;
- une borne de sortie (13c) du circuit de sortie différentielle (13) est connectée à la borne de commande (Cb) du troisième élément actif (TrC) ;
- la borne de sortie (Cc) du troisième élément actif (TrC) est connectée à une des bornes d'entrée (13a) du circuit de sortie différentielle (13) ;
- la borne de sortie (Dc) du quatrième élément actif (TrD) est connectée à l'autre borne d'entrée (13b) du circuit de sortie différentielle (13) ; et
- une borne de commande (Db) du quatrième élément actif (TrD) est connectée à l'autre borne d'entrée (IN(+)) pour les signaux d'entrée compensée.

2. Circuit d'isolation selon la revendication 1, dans lequel chacun des premier à quatrième éléments actifs (TrA, TrB, TrC, TrD) est un transistor.

3. Circuit d'isolation selon la revendication 1, dans lequel une tension constante (12) est appliquée à la borne de commande (Bb) du second élément actif (TrB).

4. Circuit d'isolation selon la revendication 2, dans lequel des bornes d'émetteur ou de source des premier à quatrième éléments actifs sont connectées à une source C.C. (14, 15) par l'intermédiaire de résistances (R1) possédant chacune une valeur prédéterminée.
